# EUROPÄISCHE PATENTSCHRIFT

(11) **EP 2 541 637 B1**
(45) Veröffentlichungstag und Bekanntmachung des Hinweises auf die Patenterteilung: **12.01.2022**
(21) Anmeldenummer: 11172129.6
(22) Anmeldetag: 30.06.2011
(51) Int. Cl.: H01L 51/52

(54) **Elektrolumineszente Lichtemissionseinrichtung mit einer optischen Gitterstruktur und Verfahren zur Herstellung derselben**
Electroluminescent light emission device with an optical grid structure and method for production of same
Dispositif d'émission de lumière électroluminescente doté d'une structure de grille optique et son procédé de fabrication

(43) Veröffentlichungstag der Anmeldung: 02.01.2013
(73) Patentinhaber: Fraunhofer-Gesellschaft zur Förderung der angewandten Forschung e.V., 80686 München (DE)
(72) Erfinder: Pfeifer, Richard, 01099 Dresden (DE); Fehse, Karsten, 01109 Dresden (DE); Vogel, Uwe, 01324 Dresden (DE); Leo, Karl, 01219 Dresden (DE)
(74) Vertreter: Hersina, Günter

(56) Entgegenhaltungen:
- EP-A2- 2 339 658
- WO-A1-2011/024753
- JP-A- 11 307 266
- JP-A- 2002 056 988
- US-A1- 2002 080 493
- US-A1- 2005 275 994
- US-A1- 2010 141 612

## Beschreibung

Die vorliegende Erfindung bezieht sich auf eine elektrolumineszente Lichtemissionseinrichtung, wie z.B. eine organische Leuchtdiode bzw. OLED (organic light emitting diode), mit einer optischen Gitterstruktur zur Verbesserung der Lichtauskopplung und auf ein Verfahren zur Herstellung derselben.

OLEDs finden immer stärker Anwendung im Bereich der Beleuchtung sowie auch der Displaytechnologie. Hierzu tragen besonders die potentiell hohe Effizienz, der erreichbare Farbraum und die mögliche dünne Bauform von OLEDs bei.

Die Effizienz einer OLED wird durch verschiedene Faktoren bestimmt, von denen bei hocheffizienten OLEDs vor allem die Lichtauskopplungseffizienz die Gesamteffizienz beschränkt. Während innerhalb der organischen Schichten das Licht hocheffizient erzeugt wird, kann nur ein geringer Anteil des Lichtes aus der OLED ausgekoppelt und als Nutzlicht verwendet werden. Bedingt durch den hohen Brechungsindex von organischen Schichten von ca. 1,7 bleibt ein großer Anteil des Lichts in der organischen, lichtemittierenden Schicht in Form von Lichtmoden gebunden. Bei OLEDs auf transparenten Substraten tritt ein Teil des Lichts in das Substrat ein und bleibt dort in Form von Substratmoden gebunden und wird nicht ausgekoppelt. Insgesamt gehen durch diese Effekte und durch zusätzliche Anregungen von Plasmonmoden sowie durch Absorption ca. 75% bis 80% des generierten Lichts verloren. Eine effiziente Auskopplung des Lichts aus der organischen Schicht würde deshalb die Gesamteffizienz von OLEDs deutlich erhöhen. Durch die Erhöhung der Gesamteffizienz würden insbesondere mobile Anwendungen wie Mikrodisplays auf OLED-Basis, aber auch Beleuchtungslösungen profitieren.

Die Patentschrift US 2010/0141612 A1 zeigt ein organisches elektrolumineszentes Element mit Elektroden und eine oder mehrere zwischen den Elektroden angeordnete organische Schichten, die eine Lumineszenzschicht aufweisen. Hier ist innerhalb der mehrschichtigen ersten Elektrode die periodische Struktur angeordnet.

Die Patentschrift EP 2 339 658 A2 zeigt ein organisches lichtemittierendes Element mit einer lichtemittierenden Schicht und einer Zwischenschicht zwischen erster Elektrode und lichtemittierender Schicht, wobei die Zwischenschicht erste und zweite Gitterteilbereiche aus Metall und Dielektrikum umfasst.

Die Aufgabe der vorliegenden Erfindung besteht darin, die Gesamteffizienz von elektrolumineszenten Lichtemissionseinrichtungen durch eine verbesserte Lichtauskopplung zu erhöhen und ein Verfahren zur Herstellung von elektrolumineszenten Lichtemissionseinrichtungen mit hoher Gesamteffizienz zu schaffen.

Diese Aufgabe wird durch eine elektrolumineszente Lichtemissionseinrichtung gemäß Anspruch 1 und ein Herstellungsverfahren gemäß Anspruch 10 gelöst. Erfindungsgemäße Weiterbildungen sind in den Unteransprüchen definiert.

Die Erkenntnis der vorliegenden Erfindung besteht darin, dass das in der organischen, lichtemittierenden Schicht gebundene Licht gezielt mit einer periodisch strukturierten und leitfähigen, möglichst planaren Zwischenschicht, d.h. einer möglichst planaren Gitterstruktur, beeinflusst werden kann, ohne dabei die Topologie der planaren, organischen Schicht bzw. des planaren, organischen Schichtstapels zu verändern. Dazu wird die strukturierte, möglichst planare Zwischenschicht mit der optischen Gitterstruktur zwischen einer Elektrodenschicht und der organischen, lichtemittierenden Schicht platziert, so dass die Zwischenschicht mit den optischen Gitterstrukturen als optisches Gitter mit den Lichtmoden des in der organischen, lichtemittierenden Schicht erzeugten Lichts koppeln kann. Der beschriebe Aufbau des optischen Gitters aus mindestens einem leitfähigen Material macht die Platzierung des optischen Gitters zwischen den Elektrodenschichten, d.h. innerhalb des optischen Resonators, möglich. Dadurch wird die Kopplung des optischen Gitters an das Licht in den organischen Schichten verstärkt. Die möglichst planare Oberfläche der Zwischenschicht mit den optischen Gitterstrukturen ermöglicht es, die organischen Schichten ohne Störung der Topologie abzuscheiden und eine hohe Effizienz der Lichterzeugung in der organischen Schicht (bzw. dem Schichtstapel) zu ermöglichen.

Ein Ausführungsbeispiel der vorliegenden Erfindung schafft eine Lichtemissionseinrichtung mit einem Substrat und einer auf dem Substrat aufgebrachten Schichtanordnung. Die Schichtanordnung weist eine erste Elektrodenschicht aus einem leitfähigen Material, eine zweite Elektrodenschicht aus einem leitfähigen Material und zumindest eine lichtemittierende Schicht aus einem organischen Material, die zwischen der ersten Elektrodenschicht und der zweiten Elektrodenschicht angeordnet ist, auf. Dabei ist die lichtemittierende Schicht als organischer Schichtstapel ausgeführt. Ferner umfasst die Schichtanordnung zumindest eine eine optische Gitterstruktur aufweisende Zwischenschicht, die zwischen der lichtemittierenden Schicht und der ersten Elektrodenschicht angeordnet ist. Eine erste Hauptoberfläche der Zwischenschicht ist der lichtemittierenden Schicht zugewandt, wobei die erste Hauptoberfläche der Zwischenschicht zumindest im Bereich der optischen Gitterstruktur möglichst planar ausgebildet ist, und wobei die Zwischenschicht zumindest bereichsweise zwischen der ersten Hauptoberfläche und einer zweiten Hauptoberfläche derselben leitfähig ist. Weiterhin umfasst die Zwischenschicht erste und zweite Gitterteilbereiche, wobei die Gitterteilbereiche nebeneinander angeordnet sind und wobei die ersten und zweiten Gitterteilbereiche die gleiche Schichthöhe aufweisen, um so eine konstante Schichtdicke der Zwischenschicht auszubilden und wobei die ersten Gitterteilbereiche ein dotiertes amorphes Silizium und die zweiten Gitterteilbereiche ein Siliziumoxid aufweisen. In diesem Ausführungsbeispiel weist der organische Schichtstapel eine Löchertransportschicht, eine Elektronenblockerschicht, eine lichtemittierende Schicht, eine Löcherblockerschicht und eine Elektronentransportschicht auf, und die erste Hauptfläche der Zwischenschicht grenzt direkt an den organischen Schichtstapel an.

Bei diesem Ausführungsbeispiel kann die Lichtauskopplung und damit die Effizienz der Lichtemissionseinrichtung verbessert werden kann, indem die (möglichst) planare Zwischenschicht mit der optischen Gitterstruktur in der Schichtanordnung in unmittelbarer Nähe zur organischen Schicht angeordnet ist. Des Weiteren ist es vorteilhaft, dass mit einer derartigen Lichtemissionseinrichtung eine Winkelabhängigkeit der Lichtemission mittels der Zwischenschicht gesteuert werden kann, was insbesondere im Fall von Anwendungen mit begrenzter Apertur die Effizienz weiter erhöht. Durch die möglichst planare Oberfläche der periodisch strukturierten Zwischenschicht wird die Topologie der organischen Schicht nicht beeinflusst, so dass die elektrischen Eigenschaften und damit die Effizienz nicht beeinträchtigt werden. Da aber beispielsweise mit üblichen Halbleiter-Herstellungsverfahren häufig fertigungsbedingt keine ideal plane bzw. planare Oberfläche z.B. der Zwischenschicht mit der optischen Gitterstruktur hergestellt werden kann, werden durch einen Toleranzbereich die maximal zulässigen bzw. herstellungstechnisch erreichbare Unebenheiten der ersten Hauptoberfläche der Zwischenschicht in einem Bereich von weniger als +/-20 nm definiert, so dass der organische Schichtstapel auf eine annähernd planare Oberfläche aufgebracht werden kann, bei der die Topologie des organischen Schichtstapels und damit die elektrischen und optischen Eigenschaften desselben nicht negativ beeinflusst werden.

Die optische Gitterstruktur umfasst somit erste und zweite Gitterteilbereiche, deren unterschiedliche Materialien dotiertes amorphes Silizium und Siliziumoxid unterschiedliche Materialeigenschaften mit unterschiedlichen Brechungsindizes aufweisen. Die Periodenlänge der optischen Gitterstruktur kann zumindest bereichsweise auf eine Wellenlänge des von der lichtemittierenden Schicht zu emittierenden Lichts eingestellt sein, so dass die Periodenlänge der optischen Gitterstruktur in einem Bereich von einem 0,2- bis 5,0-fachen Wert der Wellenlänge des zu emittierenden Lichts liegt. Hierbei ist vorteilhaft, dass die Gitterstruktur und damit die Auskoppelung des Lichts bereichsweise optimal auf das zu emittierende Licht der Lichtemissionseinrichtung abgestimmt werden kann. Um über die Breite der optischen Gitterstruktur der Zwischenschicht, die beispielsweise eine Schichtdicke von maximal bis zu 1000 nm aufweist, konstante Gittereigenschaften zu ermöglichen, ist die Schichtdicke entsprechend den erfindungsgemäßen Ausführungsbeispielen in einem Toleranzbereich im Bereich der fertigungsbedingten Unebenheiten der ersten Hauptfläche in einem Bereich von weniger als +/- 20 nm konstant.

Ein weiteres , nicht beanspruchtes Beispiel der Lichtemissionseinrichtung weist eine zusätzliche leitfähige Ladungstransportschicht zwischen dem organischen Schichtstapel und der Zwischenschicht auf. Diese laterale Ladungstransportschicht dient dazu, die Licht-emittierende, organische Schicht elektrisch über die gesamte Fläche zu kontaktieren, auch wenn die Zwischenschicht nur bereichsweise, z.B. in den ersten oder zweiten Gitterteilbereichen leitfähig ist. Der Vorteil der Ladungstransportschicht liegt darin, dass selbst bei großen Periodenlängen die Funktion ohne eine Beeinträchtigung der elektrischen Eigenschaften der Lichtemissionseinrichtung sichergestellt wird. Entsprechend einem weiteren Ausführungsbeispiel umfasst die Schichtanordnung eine zusätzliche homogene, leitfähige Distanzschicht zwischen der Zwischenschicht und einer der Elektrodenschichten, die zur Optimierung der Position der optischen Gitterstruktur innerhalb des Resonators, d.h. innerhalb der Schichtanordnung dient. Dies bietet den Vorteil, die Lichtauskoppelungseffizienz weiter zu optimieren.

Entsprechend einem weiteren Ausführungsbeispiel kann die Schichtanordnung in Pixel und/oder in Subpixel unterteilt sein, wobei die Pixel und/oder Subpixel selektiv, passiv oder aktiv mittels einer integrierten Schaltung angesteuert werden können. Dieses vorteilhafte Ausführungsbeispiel ermöglicht beispielsweise die Aktivierung von einzelnen Pixeln einer Lichtemissionseinrichtung, die mehrere Pixel aufweist, so dass die Lichtemissionseinrichtung als Display mit einer optimierten Lichtauskopplungseffizienz genutzt werden kann. Im Weiteren wird durch die Subpixel unterschiedlicher Farben eine variable Farb-Darstellung ermöglicht.

Entsprechend einem weiteren Ausführungsbeispiel kann die Lichtemissionseinrichtung zwei jeweils mit einer optischen Gitterstruktur versehene Zwischenschichten aufweisen. Dabei weist die erste Zwischenschicht die in Anspruch 1 definierten Merkmale auf. Hierbei ist die zweite Zwischenschicht zwischen der ersten Zwischenschicht und der ersten Elektrodenschicht angeordnet, wobei jeweils die erste Hauptoberfläche der Zwischenschicht, die der lichtemittierenden Schicht zugewandt ist, zumindest im Bereich der optischen Gitterstruktur innerhalb des Toleranzbereichs planar ausgebildet ist. Des Weiteren sind die erste und zweite Zwischenschicht zumindest bereichsweise zwischen den ersten Hauptoberflächen und zweiten Hauptoberflächen derselben leitfähig. Es ist vorteilhaft, dass durch die weitere Zwischenschicht die Lichtauskopplung für mehrere Farben optimiert werden kann und das Licht zugleich in mehrere Richtungen gezielt ausgekoppelt werden kann.

Ein weiteres Ausführungsbeispiel der vorliegenden Erfindung bezieht sich auf das in Anspruch 10 definierte Verfahren zur Herstellung einer Lichtemissionseinrichtung mit einer Schichtanordnung. Das Verfahren umfasst folgende Schritte: Bereitstellen eines Substrats und Anordnen einer ersten Elektrodenschicht auf dem Substrat. Erzeugen der in Anspruch 1 definierten eine optische Gitterstruktur aufweisende, planarisierte Zwischenschicht auf der ersten Elektrodenschicht, wobei die planarisierte Zwischenschicht zumindest bereichsweise zwischen einer ersten und einer zweiten Hauptoberfläche derselben leitfähig ist. Anordnen des in Anspruch 1 definierten eine lichtemittierende Schicht aufweisenden organischen Schichtstapels auf der Zwischenschicht und Anordnen einer zweiten Elektrodenschicht auf dem organischen Schichtstapel.

Der Vorteil dieses Herstellungsverfahrens ist, dass eine auf effiziente Lichtauskopplung optimierte Lichtemissionseinrichtung mit einer optischen Gitterstruktur prozesssicher und kostengünstig hergestellt werden kann, bei der die elektrischen Eigenschaften aufgrund der Planarisierung nicht beeinträchtigt werden.

Entsprechend einem weiteren Ausführungsbeispiel kann die planarisierte Zwischenschicht mit den folgenden Schritten hergestellt werden: Aufbringen einer ersten Gitterstruktur-Basisschicht auf der Elektrodenschicht. Strukturieren der ersten Gitterstruktur-Basisschicht, um erste beabstandete Gitterteilbereiche und freigelegte Zwischenbereiche zu erhalten. Aufbringen einer zweiten Gitterstruktur-Basisschicht auf den ersten, beabstandeten Gitterteilbereichen und den freigelegten Zwischenbereichen. Planarisieren der zweiten Gitterstruktur-Basisschicht, um die planarisierte Zwischenschicht mit der optischen Gitterstruktur zu erhalten. Ein weiteres Ausführungsbeispiel des Herstellungsverfahrens einer Lichtemissionseinrichtung umfasst ferner den Schritt des Erzeugens einer weiteren planarisierten Zwischenschicht mit einer weiteren optischen Gitterstruktur auf der planarisierten Zwischenschicht. Die planarisierte weitere Zwischenschicht ist zumindest bereichsweise zwischen einer ersten und einer zweiten Hauptoberfläche leitfähig.

Im Folgenden werden nun anhand weiterer Dokumente zum Stand der Technik auf kritische Eigenschaften herkömmlicher OLED-Strukturen eingegangen, wobei ferner die Erkenntnisse und erfindungsgemäßen Schlussfolgerungen der Erfinder unter Berücksichtigung der der vorliegenden Erfindung zugrunde liegenden Aufgabe herausgestellt werden. Zur Lösung des Auskopplungsproblems wurden bereits verschiedene Ansätze untersucht, wobei zwischen drei Ansätzen des OLED-Aufbaus zu unterscheiden ist. Zum einen kann das Licht direkt in die substratabgewandte Seite durch eine transparente Deckelelektrode emittiert werden. Derartige OLEDs werden top-emitting OLEDs (Deckkontaktemittierende OLEDs) oder TOLEDs genannt. Hierbei wird ein opakes Substrat genutzt. Bei der Verwendung von transparenten Substraten kann das Licht auch durch das Substrat selbst emittiert werden. Die durch das Substrat emittierende OLEDs werden bottomemitting OLEDs (Substrat-emittierende OLEDs) oder BOLEDs genannt. Hierbei werden dann transparente Substratkontakte und opake Deckelkontakte genutzt. Des Weiteren kann bei sogenannten transparenten OLEDs unter Verwendung von transparentem Substrat und eines transparenten Deckelkontakts das Licht substratseitig und deckelkontaktseitig emittierte werden. Bei BOLEDs besteht die Möglichkeit, die Auskopplungseffizienz durch Auskopplung des im Substrat gebundenen Lichtes zu verbessern, indem beispielsweise das Substrat strukturiert [2] oder aufgeraut [3] wird. Weitere Möglichkeiten hierbei sind die Einführung von Streuschichten [4] oder Schichten mit niedrigem Brechungsindex [5].

Von besonderer Bedeutung ist die Verwendung von periodisch strukturierten Schichten, um die Lichtausbreitung durch Beugung des Lichtes gezielt zu beeinflussen. Optische Gitter aus Materialien mit unterschiedlichen Brechungsindizes, deren Periodenlänge in der Größenordnung der Wellenlänge des emittierten Lichtes liegt, können das Licht gezielt in den Außenraum lenken. Hierbei kann die Winkelverteilung des emittierten Lichtes beeinflusst werden, so dass die Lichtauskopplung optimiert wird. Dies ist besonders bei bestimmten Anwendungen von Bedeutung, bei denen nur der Teil des Lichtes genutzt wird, der in einem bestimmten Winkelbereich emittiert wird. Ein Beispiel dafür ist ein Mikrodisplay, bei dem das durch die OLED erzeugte Licht durch weitere optische Baugruppen geleitet wird, die nur eine begrenzte Apertur haben. Insofern kann eine gezielte Beeinflussung der Winkelabhängigkeit der emittierten Strahlung die Systemeffizienz von solchen Anwendungen ebenfalls deutlich verbessern.

Um effektiv das in den organischen Moden gebundene Licht auskoppeln zu können, ist beispielsweise bei OLEDs bzw. BOLEDs versucht worden, periodische Strukturen in unmittelbarer Nähe der organischen Schichten zu platzieren. Die vorliegenden Erfinder haben erkannt, dass die Integration einer optischen Gitterstruktur zwischen den Elektroden sich schwierig gestaltet, da die organischen Materialien aufgrund ihrer Empfindlichkeit beispielsweise gegenüber Temperatur den Gitterherstellungsprozess einschränken. Bei bestehenden Lösungen soll dieses Problem umgangen werden, indem zunächst der Gitterstrukturierungsprozess durchgeführt wird und anschließend die organischen Schichten abgeschieden werden. Eine übliche Ausführungsform hierbei ist die Strukturierung des Substrats oder einer Zwischenschicht, um darauf dann die Substratelektrode abzuscheiden [7, 8, 9]. Die Elektrode und damit auch die organische Schicht weisen infolgedessen dieselbe Topologie wie das strukturierte Substrat auf. Weitere Ausführungsformen weisen eine nachträgliche Strukturierung der auf dem Substrat abgeschiedenen Elektrode [US 2004/0012328 A1] bzw. eine Abscheidung von periodischen Strukturen auf der Elektrode auf [US 2010/0283068 A1]. In diesen Ausführungsformen wird die Topologie der Elektrode auf die organische Schicht übertragen.

Hinsichtlich dieser Lösungsvarianten, bei denen jeweils die organische Schicht auf eine strukturierte und damit nicht plane Oberfläche abgeschieden wird, hat sich herausgestellt bzw. wurde durch die vorliegenden Erfinder erkannt, dass die Lichtauskopplung nicht optimal ist. Der Grund hierfür liegt darin, dass die Schichtdicke der organischen Schicht als direkte Folge der Strukturierung über die gesamte Leuchtfläche nicht konstant ist. Die Strukturierung von metallischen Elektroden führt zur Anregung von plasmonischen Moden, die wiederum zur Absorption des Lichtes führen können und somit die Lichtauskopplung verschlechtern. Des Weiteren hat sich herausgestellt, dass hierdurch die elektrischen Eigenschaften der OLED negativ beeinträchtigt werden. Die durch die Strukturierung verursachten Kanten und Schrägen können beispielsweise zu Kurzschlüssen zwischen Elektroden oder einer Erhöhung der Verlustströme führen [11].

Weitere derzeitige Lösungen für BOLEDs auf transparenten Substraten mit (semi-) transparenten Substratelektroden bestehen darin, die Gitterschichten zwischen Substrat und Elektrode zu platzieren [US 2009/0015142 A1, US2006/0071233 A1, US 2008/0284320 A1, US 7696687 B2, US 2007/0241326 A1]. Hierdurch werden die elektrischen Eigenschaften der OLED nicht derart beeinträchtigt wie die hinsichtlich der obigen drei Lösungen dargestellt wurde. Es hat sich aber herausgestellt bzw. die vorliegenden Erfinder haben erkannt, dass aufgrund der entfernten Position des optischen Gitters von der organischen Schicht, nämlich zwischen Elektrode und Substrat, die Lichtauskopplung nicht optimal ist.

Ausführungsbeispiele der Erfindung werden nachfolgend Bezug nehmend auf die beiliegenden Zeichnungen näher erläutert. Es zeigen:
- Fig. 1: eine schematische Schnittdarstellung einer Lichtemissionseinrichtung mit einer Schichtanordnung, die eine Zwischenschicht mit einer optischen Gitterstruktur aufweist, entsprechend einem Ausführungsbeispiel;
- Fig. 2a-2c: eine schematische Darstellung einer Lichtemissionseinrichtung sowie Darstellungen entsprechender Optimierungsparameter;
- Fig. 3: eine schematische Schnittdarstellung einer Lichtemissionseinrichtung mit einer Schichtanordnung, die eine Zwischenschicht mit einer optischen Gitterstruktur und eine laterale Ladungstransportschicht aufweist, entsprechend einem nicht beanspruchten Vergleichsbeispiel;
- Fig. 4: eine schematische Schnittdarstellung einer Lichtemissionseinrichtung mit einer Schichtanordnung, die eine Zwischenschicht mit einer optischen Gitterstruktur und eine Distanzschicht aufweist, entsprechend einem weiteren Ausführungsbeispiel;
- Fig. 5: eine schematische Schnittdarstellung einer Lichtemissionseinrichtung mit einer Schichtanordnung, die zwei Zwischenschichten mit optischen Gitterstrukturen, laterale Ladungstransportschichten und weitere Distanzschichten aufweist, entsprechend einem weiteren nicht beanspruchten Vergleichsbeispiel; diese Vergleichsbeispiel ist nützlich, um ein Ausführungsbeispiel mit zwei Zwischenschichten ohne laterale Ladungstransportschicht 26_1 zu verstehen; und
- Fig. 6a-6e: eine Verfahren zur Herstellung einer Lichtemissionseinrichtung anhand von fünf Teilprozessschritten entsprechend einem Ausführungsbeispiel.

Bevor nachfolgend die vorliegende Erfindung im Detail anhand der Zeichnungen näher erläutert wird, wird darauf hingewiesen, dass identische, funktionsgleiche oder gleichwirkende Elemente und Strukturen in den unterschiedlichen Figuren mit den gleichen Bezugszeichen versehen sind, so dass die in den unterschiedlichen Ausführungsbeispielen dargestellte Beschreibung der mit gleichen Bezugszeichen versehenen Elemente und Strukturen untereinander austauschbar ist bzw. aufeinander angewendet werden kann.

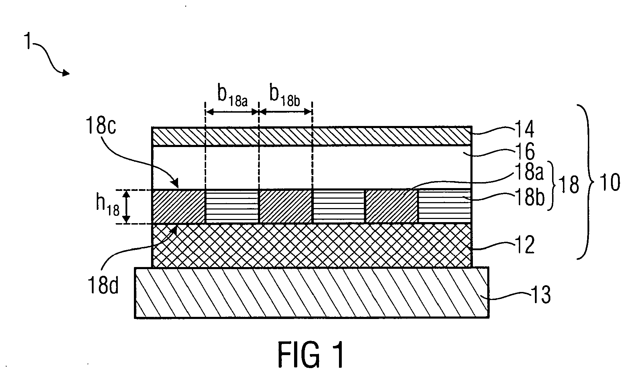

Anhand von Fig. 1 wird eine (flächige) elektrolumineszente Lichtemissionseinrichtung 1 gemäß einem ersten Ausführungsbeispiel der vorliegenden Erfindung beschrieben. Fig. 1 zeigt dabei insbesondere eine Schichtanordnung 10 der Lichtemissionseinrichtung 1, die auf ein Substrat 13 aufgebracht ist. Die Schichtanordnung 10 weist eine erste Elektrodenschicht 12 und eine zweite Elektrodenschicht 14 auf, welche beide ein leitfähiges Material, wie z.B. Aluminium, aufweisen. Zwischen den zwei Elektrodenschichten 12 und 14 ist eine lichtemittierende Schicht 16 aus einem organischen Material angeordnet. Diese lichtemittierende Schicht ist als Schichtstapel mit mehreren organischen Einzelschichten ausgeführt . Zwischen der ersten Elektrodenschicht 12 und der lichtemittierenden Schicht 16 ist eine Zwischenschicht 18 mit einer optischen Gitterstruktur vorgesehen. Eine erste Hauptoberfläche 18c der Zwischenschicht 18, die möglichst planar ist, grenzt direkt an den organischen Schichtstapel an, während eine zweite Hauptoberfläche 18d der ersten Elektrodenschicht 12 zugewandt ist. Die Zwischenschicht 18 weist eine optische Gitterstruktur auf, die bei diesem Ausführungsbeispiel mittels erster Gitterteilbereiche 18a und zweiter Gitterteilbereiche 18b ausgeführt ist. Die Gitterteilbereiche 18a und 18b haben unterschiedliche Brechungsindizes und sind periodisch mit einer Periodenlänge, die der Summe der lateralen Breiten b₁₈ₐ und b_{18b} der Gitterteilbereiche 18a und 18b entspricht, angeordnet. Bei diesem Ausführungsbeispiel sind die lateralen Breiten b₁₈ₐ bzw. b_{18b} der Gitterteilbereiche 18a und 18b gleich groß, wobei die Gitterteilbereiche 18a und 18b auch unterschiedliche Breiten b₁₈ₐ und b_{18b} aufweisen können, damit optischen Eigenschaften der Zwischenschicht 18 abhängig von der Gitterstruktur je Anwendungsgebiet einstellbar bzw. wählbar sind. Die Zwischenschicht 18 und damit auch die Gitterteilbereiche 18a und 18b haben in erfindungsgemäßen Ausführungsbeispielen eine konstante Schichtdicke h₁₈ zwischen der ersten und zweiten Hauptoberfläche 18c und 18d. Das Substrat 13, auf dem die Elektrodenschicht 12 und damit die Schichtanordnung 10 angeordnet ist, weist beispielsweise opakes Silizium oder transparentes Glas auf. Im Folgenden wird die Funktionsweise dieses Ausführungsbeispiels näher erläutert.

Mittels eines elektrischen Stroms zwischen der ersten Elektrodenschicht 12 und der zweiten Elektrodenschicht 14 und durch die lichtemittierende, organische Schicht 16 wird hierdurch in der organischen Schicht 16 eine Lichtemission angeregt. Um das emittierte Licht effizient auskoppeln zu können und Verluste in Substrat- oder Organikmoden zu vermeiden, wird das emittierten Licht bzw. Lichtmoden in der Zwischenschicht 18 mittels der optischen Gitterstruktur gerichtet bzw. ausgerichtet. Diese Ausrichtung der Lichtmoden erfolgt aufgrund von Beugung an der optischen Gitterstruktur bzw. an den Gitterteilbereichen 18a und 18b, die beispielsweise unterschiedliche Brechungsindices aufweisen. Um einen Gradienten der Brechungsindices auszubilden, sind die ersten Gitterteilbereiche 18a aus dotiertem amorphem Silizium und die zweiten Gitterteilbereiche 18b aus Siliziumoxid und weisen somit unterschiedliche Materialeigenschaften auf.

Ein Stromfluss zwischen der ersten Elektrodenschicht 12 und der zweiten Elektrodenschicht 14 durch die lichtemittierende Schicht 16 wird ermöglicht, indem die Zwischenschicht 18 zumindest bereichsweise zwischen der ersten und zweiten Hauptoberfläche 18c und 18d leitfähig ist , weil die Gitterteilbereiche 18a aus dem leitfähigen Material dotiertes amorphes Silizium ausgeführt sind.

Um die elektrischen Eigenschaften der organischen, lichtemittierenden Schicht 16 nicht zu beeinträchtigen, ist die lichtemittierende Schicht 16 auf der im Idealfall planaren Oberfläche, nämlich ersten Hauptoberfläche 18c angeordnet. Da fertigungsbedingt keine ideal planare Oberfläche herstellbar ist, wird ein Toleranzbereich festgelegt, der einerseits die gestellten Anforderungen hinsichtlich Planarität der organischen Schicht 16 erfüllt und andererseits fertigungstechnisch herstellbar ist. Der in den erfindungsgemäßen Ausführungsbeispielen festgelegte Toleranzbereich gibt Unebenheiten der ersten Hauptoberfläche 18c in einem Bereich von weniger als +/- 20 nm an, d.h. die maximale Abweichung eines Punktes der ersten Hauptoberfläche 18c im Bereich der optischen Gitterstruktur von der idealen planaren Ebene beträgt 20 nm in einer ersten Richtung (Richtung lichtemittierende Schicht 16) oder in einer zweiten, entgegengesetzten Richtung (Richtung erste Elektrodenschicht 12). Es wird angemerkt, dass größere Unebenheiten außerhalb des Bereichs der optischen Gitterstruktur der Zwischenschicht 18 bzw. außerhalb der lichtemittierenden Bereiche der organischen Schicht 16 zulässig sein können, da Unebenheiten in diesen Bereichen einen vernachlässigbaren Einfluss auf die resultierenden elektrischen und optischen Eigenschaften haben. Der Toleranzwert von +/-20 nm begründet sich damit, dass typischer Weise die elektrischen Eigenschaften der organischen, lichtemittierenden Schicht 16 durch Unebenheiten innerhalb dieses Toleranzbereichs nicht signifikant beeinträchtigt werden, und dadurch, dass typische Planarisierungsverfahren Oberflächen mit einer maximalen Oberflächenunebenheit bzw. Rauheit von weniger als +/-20 nm erzeugen können. Hintergrund für die Oberflächenunebenheit ist, dass bei Planarisierungsverfahren, wie z.B. chemischmechanischen Polieren (CMP), prozessbedingte Oberflächenunebenheiten bzw. Rauheiten nach dem Schleifprozess zurück bleiben. Bei der Planarisierung dient der eine der beiden Gitterteilbereiche 18a oder 18b als Stopschicht bzw. Ätzstopschicht. Hinzu kommt, dass bei der Planarisierung der Zwischenschicht 18, die erste und zweite Gitterteilbereiche 18a und 18b aufweist, sogenannte Stufen entstehen, da die Gitterteilbereiche 18a und 18b unterschiedliche Materialeigenschaften aufweisen, die sich auf die Planarisierung auswirken. An dieser Stelle wird angemerkt, dass unterschiedliche Typen organischer Schichten unterschiedliche Anforderungen an die Oberflächenunebenheit des Untergrunds stellen, so dass in weiteren Ausführungsbeispielen die Hauptoberfläche 18c innerhalb eines Toleranzbereichs von +/- 20 nm, +/- 10 nm oder +/- 5 nm planar ist.

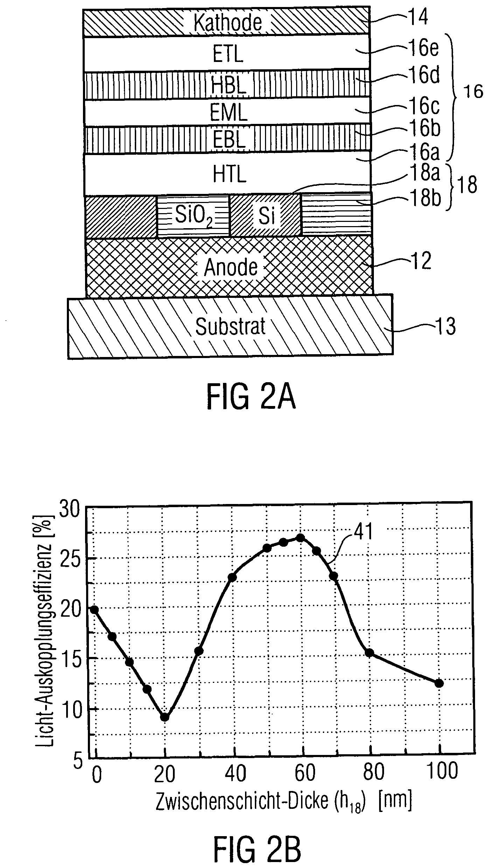

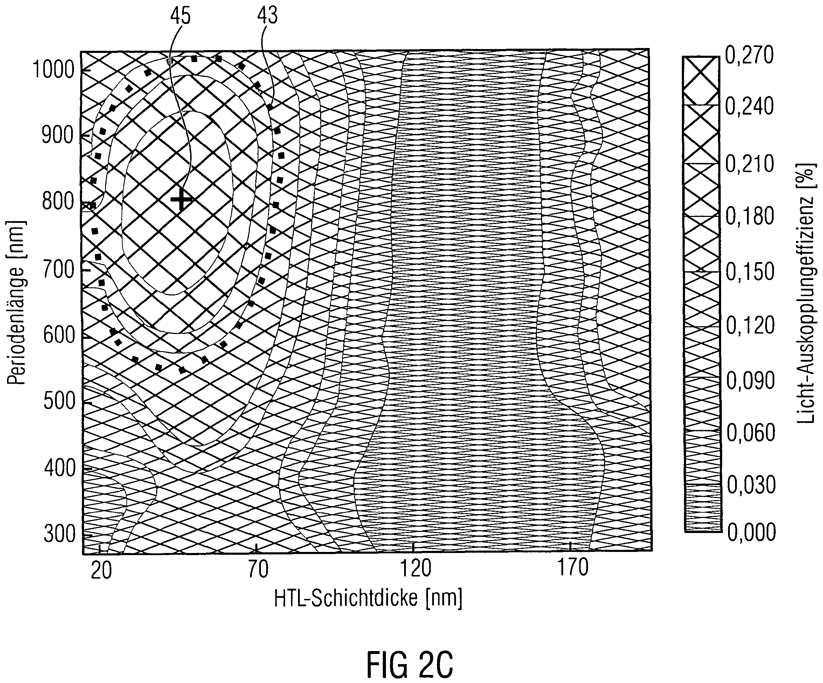

Fig. 2a zeigt das erfindungsgemäße Ausführungsbeispiel einer Lichtemissionseinrichtung bei der die organische lichtemittierende Schicht 16 als Schichtstapel ausgeführt ist. Fig. 2b illustriert die Abhängigkeit der Lichtauskopplungseffizienz von der Schichtdicke h₁₈ der Zwischenschicht 18. Fig. 2c stellt die Abhängigkeit der Lichtauskopplungseffizienz von der Periodenlänge und Schichtdicke einer der organischen Schichten (HTL-Schicht) des Schichtstapels dar.

Fig. 2a zeigt ein exemplarisches Ausführungsbeispiel einer phosphoreszenten Lichtemissionseinrichtung (OLED), die Licht mit einem grünen Spektralanteil emittieren kann. Bei diesem Ausführungsbeispiel weist die erste Elektrodenschicht 12, die als Anode bezeichnet ist, Aluminium mit einer Schichtdicke von 200 nm (z.B. 180 - 240 nm) auf. Die zweite Elektrodenschicht 14, die als Kathode bezeichnet wird, weist semitransparentes Silber auf und hat beispielsweise eine Schichtdicke von ca. 20 nm. Die lichtemittierende Schicht 16 ist bei diesem Ausführungsbeispiel mittels eines Schichtstapels aus fünf Einzelschichten realisiert. Die erste Einzelschicht ist eine Löchertransportschicht 16a (HTL = hole transport layer), welches N',N'-tetrakis-(4-methoxyphenyl)-benzidine (MeO-TPD) als Host und 2,3,5,6-tetrafluoro-7,7,8,8,-tetracyanoquinodimethane als Dotand aufweist. Die zweite Einzelschicht ist eine Elektronenblockerschicht 16b (EBL = electron blocking layer) und weist 2,2',7,7'-tetrakis-(N,N-diphenylamino)-9,9'-spirobifluorene (Spiro-TAD) auf. Die dritte Einzelschicht ist eine Doppelemitterschicht 16c (EML = emitting layer), die beispielsweise eine Schichtdicke von 20 nm (z.B. 5 - 15 nm) aufweist und als grüner phosphoreszenter Emitter tris(2-phenylpyridine)-iridium [Ir(ppy)3], dotiert in eine Matrix aus 4,4',4"-tris(N-carbazolyl)-triphenylamine (TCTA) bzw. 2,2',2"-(1,3,5-benzenetriyl)-tris [1-phenyl-1>H-benzimidazole] (TPBI) ausgeführt ist. Die vierte Einzelschicht ist eine Löcherblockerschicht 16d (HBL = hole blocking layer) aus 4,7-diphenyl-1,10-phenanthroline (Bphen). Die letzte Einzelschicht der organischen Schicht 18 ist eine Elektronentransportschicht 16e (ETL = electron transport layer), welche Bphen und Cäsium aufweist. Die Elektronenblockerschicht 16b und die Löchertransportschicht 16a haben beispielsweise eine Schichtdicke von 10 nm (z.B. 5 - 15 nm). Die Zwischenschicht 18 weist zumindest zwei Materialien zur Bildung einer linearen, optischen Gitterstruktur auf, nämlich dotiertes amorphes Silizium als erste Gitterteilbereiche 18a und Siliziumoxid als zweite Gitterteilbereiche 18b.

Die resultierende Funktionsweise der in Fig. 2a dargestellten Lichtemissionseinrichtung entspricht grundsätzlich der in Fig. 1 dargestellten Funktionsweise, wobei die dargestellte Lichtemissionseinrichtung Licht mit einem grünen Spektralanteil emittieren kann. Es wird darauf hingewiesen, dass Lichtemissionseinrichtung mit anderen organischen Materialien in den organischen Schichten andere Spektralanteile emittieren können. Im Folgenden werden unterschiedliche Parameter, die Einfluss auf die Lichtauskopplungseffizienz haben erläutert. Im Allgemeinen ist festzustellen, dass die Periodenlänge b₁₈ₐ + b_{18b} der optischen Gitterstruktur von der Wellenlänge des zu emittierenden Lichtes abhängt bzw. entsprechend gewählt ist. Deshalb wird die Periodenlänge bereichsweise auf die Wellenlänge des zu emittierenden Lichts eingestellt, so dass die Periodenlänge in einem Bereich von einem 0,2- bis 5,0-fachen Wert der Wellenlänge liegt. Für die Lichtemissionseinrichtung mit dem grünen Spektralanteil des zu emittierenden Lichts gemäß diesem Ausführungsbeispiel ist eine Periodenlänge der optischen Gitterstruktur von beispielsweise 800 nm (z.B. 700 - 900 nm) optimal. Hinsichtlich der Schichtdicken lässt sich ein Maximum der Auskoppeleffizienz beispielsweise erreichen, wenn eine Schichtdicke der ETL-Schicht von 205 nm (z.B. 180 - 230 nm) gewählt wird und wenn die Schichtdicke der HTL-Schicht entsprechend auf 40 nm (z.B. 30 - 65 nm) festgelegt wird.

Bezug nehmend auf Fig. 2a und 2b wird die genaue Festlegung bzw. Optimierung der Parameter Periodenlänge, Schichtdicke h₁₈ der Zwischenschicht 18 und Schichtdicke der HTL-Schicht 16a beschrieben.

Fig. 2b. zeigt exemplarisch ein Diagramm der Lichtauskopplungseffizienz der Lichtemissionseinrichtung mit dem grüne Spektralanteil des zu emittierenden Lichts in Abhängigkeit der Schichtdicke h₁₈ der Zwischenschicht 18 mit einem Graphen 41, der mittels einer numerischen Simulation ermittelt wurde. Eine maximale Lichtauskopplungseffizienz liegt bei einer Schichtdicke h₁₈ von 60 nm (z.B. zwischen 50 - 65 nm) und eine minimale Lichtauskopplungseffizienz bei einer Schichtdicke h₁₈ von 20 nm. Infolgedessen wird bei dem in Fig. 2a gezeigten Ausführungsbeispiel die Schichtdicke h₁₈ auf 60 nm festgelegt. Die Auskoppelungseffizienz des beschriebenen Ausführungsbeispiels beträgt 27%, was eine Steigerung um 35% gegenüber der Auskoppelungseffizienz in Höhe von 20% einer Konfiguration ohne optische Gitterstruktur darstellt. Im Allgemeinen ist festzustellen, dass die Schichtdicke h₁₈ der Zwischenschicht 18, die typischer Weise einen Wert zwischen 5 und 1000 nm aufweist, abhängig von der Frequenz des emittierten Lichts ist und bevorzugter Weise konstant ist, damit die optischen Eigenschaften über die gesamte Breite der optischen Gitterstruktur gleich sind.

Fig. 2c zeigt exemplarisch das Simulationsergebnis der Lichtauskopplungseffizienz bei der Variation der Periodenlänge in Abhängigkeit der Schichtdicke der HTL-Schicht 16a des organischen Schichtstapels der Lichtemissionseinrichtung, die Licht mit einem grünen Spektralanteil emittieren kann. Hierbei ist die Periodenlänge über der Schichtdicke der HTL-Schicht 16a aufgetragen, wobei die unterschiedlichen Höhenlinien die Lichtauskopplungseffizienz darstellen bzw. verdeutlichen sollen. Es ist zu erkennen, dass in einem Bereich 43 die Lichtauskopplungseffizienz vergleichsweise hoch ist. Der Bereich 43 erstreckt sich über eine Periodenlänge zwischen 550 und 1000 nm bzw. eine Schichtdicke der HTL-Schicht 16a zwischen 30 und 65 nm, wobei ein absolutes Maximum (vgl. gekennzeichneter Bereich 45) etwa bei einer Periodenlänge von 800 nm und einer Schichtdicke von 40 nm liegt. Infolge dessen werden die von einander abhängigen Parameter Periodenlänge und Schichtdicke der HTL-Schicht 16a bei dem in Fig. 2a gezeigten Ausführungsbeispiel entsprechend der maximalen Lichtauskopplungseffizienz (vgl. gekennzeichneter Bereich 45) festgelegt.

Die optischen Eigenschaften der Zwischenschicht werden gemäß einem weiteren Ausführungsbeispiel über weitere Parameter eingestellt, was im Folgenden näher erläutert wird. Die unterschiedlichen Brechungsindices der ersten und zweiten Gitterteilbereiche 18a und 18b resultieren aus den unterschiedlichen Materialeigenschaften und/oder den unterschiedlichen Materialien der Gitterteilbereiche 18a und 18b. Die Brechungsindices der Gitterteilbereiche 18a und 18b stehen in gegenseitiger Abhängigkeit, in Abhängigkeit von den Brechungsindices der weiteren Schichten der Lichtemissionseinrichtung und in Abhängigkeit der Wellenlänge des zu emittierenden Lichts. Die Materialien bzw. Materialeigenschaften der ersten und/oder zweiten Gitterteilbereiche 18a bzw. 18b können sich bevorzugter Weise von dem Material oder die Materialeigenschaften der ersten Elektrodenschicht 12 unterscheiden, um Grenzflächen die unterschiedliche Brechungsindizes zwischen der ersten Elektrodenschicht 12 und den ersten oder zweiten Gitterteilbereichen 18a bzw. 18b auszubilden und so die optischen Eigenschaften einzustellen. Ein weiterer Parameter, der die optischen Eigenschaften der Zwischenschicht 18 beeinflusst, ist die Absorptionslänge der Gitterteilbereiche, die ebenfalls abhängig von der Wellenlänge des zu emittierenden Lichts eingestellt werden, so dass die Absorptionslänge bei der emittierten Wellenlänge des Lichtes mindestens 50 nm beträgt. Einen weiteren Einfluss auf die Auskoppelungseffizienz hat die optischen Gitterstruktur selbst, die beispielsweise einem schiefwinkeligen, rechtwinkeligen, rechtwinkelzentrierten, hexagonalen oder quadratischen Bravaisgitter oder einem Quasikristall entsprechen kann, um die gebunden Lichtmoden effizient und winkelgerecht auszukoppeln.

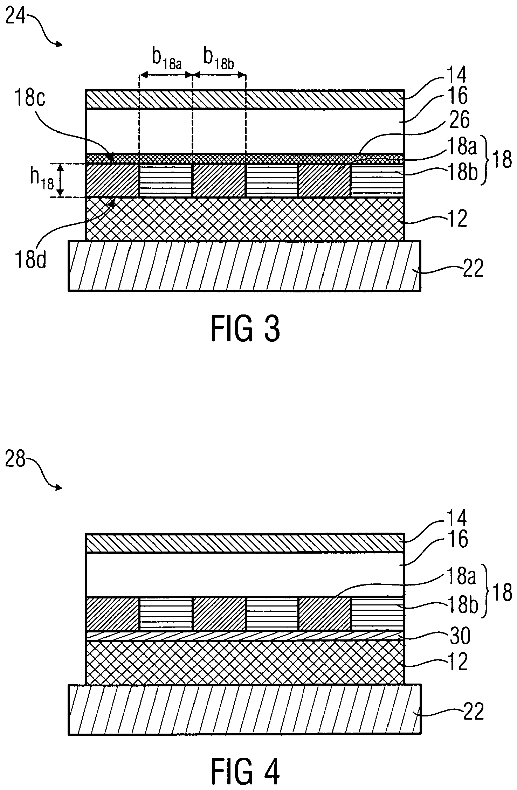

Fig. 3 zeigt eine Lichtemissionseinrichtung 24 gemäß einem weiteren nicht beanspruchten Vergleichsbeispiel.

Die Lichtemissionseinrichtung 24 weist gegenüber der Lichtemissionseinrichtung 1 eine zusätzliche (optionale) laterale Ladungstransportschicht 26 aus einem leitfähigen Material auf, die zwischen der Zwischenschicht 18 und der lichtemittierenden Schicht 16 angeordnet ist. Die laterale Transportschicht 26 ist auf der ersten planaren Hauptoberfläche 18c der Zwischenschicht 18 aufgebracht und weist, ebenso wie auch die Zwischenschicht 18, eine planare, der lichtemittierenden Schicht 16 zugeordnete Hauptoberfläche auf.

Die Lichtemissionseinrichtung 24 entspricht hinsichtlich Funktionalität grundsätzlich der Lichtemissionseinrichtung 1 aus Fig. 1. Die laterale Ladungstransportschicht 26 ist auf die planare erste Hauptoberfläche 18c der Zwischenschicht 18 aufgebracht und dient dazu, einen über die Fläche möglichst konstanten Stromfluss bzw. eine möglichst homogene Stromdichteverteilung zwischen der ersten und zweiten Elektrodenschicht 12 und 14 durch die organische, lichtemittierende Schicht 16 über die gesamte, aktive Breite der organischen Schicht 16 oder eines Pixels bzw. Subpixels der organischen Schicht 16 zu gewährleisten. Hintergrund dazu ist, mögliche Effekte, die dadurch entstehen, dass die Zwischenschicht 18 nur bereichsweise, z.B. in einem der ersten oder zweiten Gitterteilbereiche 18a oder 18b leitfähig ist, zu eliminieren. Derartige Effekte treten besonders bei Gitterstrukturen mit großen Periodenlängen auf. Die typischen Ladungstransportlängen entsprechen den lateralen Breiten b₁₈ₐ und b_{18b} der Gitterteilbereiche 18a und 18b. Diese sind üblicherweise viel kleiner als die aktive Breite der organischen Schicht, die die Ladungstransportlängen der Elektrodenschicht 12 bestimmen. Somit ist für die laterale Ladungstransportschicht 26 im Vergleich zur Elektrodenschicht 12 eine geringere Leitfähigkeit ausreichend. Die laterale Ladungstransportschicht 26 ist aus einem dünnen leitfähigen, bevorzugt transparenten Material, wie z.B. amorphem Silizium, ausgeführt. Alternativ können noch andere leitfähige Materialien, wie z.B. Indiumzinnoxid oder ein anderes transparentes leitfähige Oxid, vorzugsweise mit hohen Absorptionslängen, verwendet werden.

Fig. 4 zeigt eine Lichtemissionseinrichtung 28 gemäß einem weiteren Ausführungsbeispiel, welche gegenüber der Lichtemissionseinrichtung 1 aus Fig. 1 zusätzlich eine (optionale) Distanzschicht 30 zwischen der Zwischenschicht 18 und der ersten Elektrodenschicht 12 aufweist. Grundsätzlich entspricht die Funktionalität der Lichtemissionseinrichtung 28 der der Lichtemissionseinrichtung 1.

Die Distanzschicht 30 dient der Optimierung der Position der Zwischenschicht 18 innerhalb des Resonators, d.h. innerhalb der Schichtanordnung der Elektrodenschichten 12 und 14. Zur Optimierung wird die Schichtdicke der Distanzschicht 30 angepasst. Die Distanzschicht 30 unterscheidet sich von der Elektrodenschicht 12 hinsichtlich ihrer Leitfähigkeit. Die Distanzschicht 30 dient nur dem vertikalen Stromtransport, nicht der lateralen Verteilung von Ladungsträgern über die gesamte aktive Fläche, so dass im Vergleich zur Elektrodenschicht 12 eine geringere Leitfähigkeit ausreichend ist. Die Distanzschicht 30 kann beispielsweise aus einem dotierten Halbleiter wie amorphem Silizium oder aus transparentem und leitfähigem Metalloxid (TCO) ausgeführt sein und kann bevorzugter Weise eine lange Absorptionslänge aufweisen.

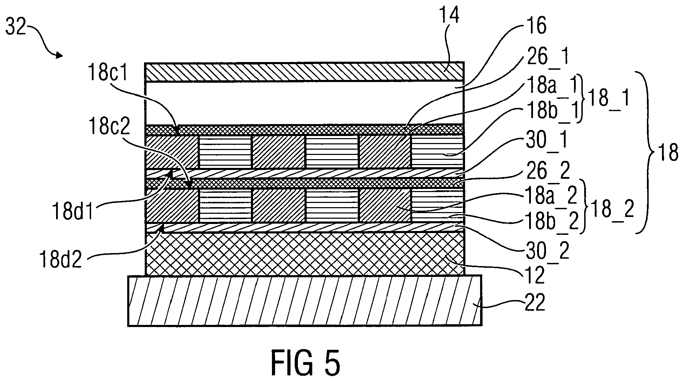

Fig. 5 zeigt eine Lichtemissionseinrichtung 32 gemäß einem weiteren nicht beanspruchten Vergleichsbeispiel, bei welchem die Zwischenschicht mit den Gitterstrukturen als Zwischenschichtstapel 18 ausgeführt ist, der zwei Zwischenschichten 18_1 und 18_2 aufweist. Die zwei Zwischenschichten 18_1 und 18 2 weisen jeweils eine optische Gitterstruktur auf. Der Schichtstapel kann ferner eine laterale Ladungstransportschicht 26_2 sowie Distanzschichten 30_1 und 30_2 aufweisen. Die Lichtemissionseinrichtung 32 umfasst das Substrat 13, auf welches die erste Elektrodenschicht 12 angeordnet ist. Zwischen der ersten Elektrodenschicht 12 und der zweiten Elektrodenschicht 14 ist die lichtemittierende Schicht 16 angeordnet. Zwischen dieser lichtemittierenden Schicht 16 und der ersten Elektrodenschicht 12 befinden sich die zwei Zwischenschichten 18 1 und 18 2. Die näher an der lichtemittierenden Schicht 16 angeordnete erste Zwischenschicht 18_1 weist erste Gitterteilbereiche 18a_1 und zweite Gitterteilbereiche 18b_1 der optischen Gitterstruktur auf. An einer zweiten, der ersten Elektrodenschicht 12 zugewandten Hauptoberfläche 18d_1 ist eine Distanzschicht 30_1 vorgesehen. Die näher an der ersten Elektrodenschicht 12 angeordnete zweite Zwischenschicht 18_2 weist analog erste Gitterteilbereiche 18a_2 und zweite Gitterteilbereiche 18b_2 auf. Analog zu der Zwischenschicht 18_1, ist auf einer ersten der lichtemittierenden Schicht 16 zugewandten Hauptoberfläche 18c_2 der Zwischenschicht 18_2 eine weitere laterale Ladungstransportschicht 26_2 und an der zweiten der ersten Elektrodenschicht 12 zugewandten Hauptoberfläche 18d_2 eine weitere Distanzschicht 30_2 vorgesehen. Dieses Vergleichsbeispiel ist nützlich, um ein Ausführungsbeispiel ohne laterale Ladungstransportschicht 26_1 zu verstehen.

Hinsichtlich Funktionalität entspricht die Lichtemissionseinrichtung 32 den vorher genannten Ausführungsbeispielen, wobei die zusätzliche Zwischenschicht 18_2 mit ihrer optischen Gitterstruktur parallel zur Zwischenschicht 18_1 angeordnet ist, um die Effekte mehrerer optischer Gitterstrukturen zu überlagen. Deshalb kann die Zwischenschicht 18_2 im Vergleich zu der Zwischenschicht 18_1 andere Gittereigenschaften, wie z.B. eine andere Periodenlänge, aufweisen. Hierdurch kann einerseits die Auskopplung für mehrere Farben optimiert werden und andererseits ermöglicht werden, Licht in mehrere Richtungen zugleich gezielt auszukoppeln. Analog zu dem oben genannten Vergleichsbeispiel dienen die (optionalen) lateralen Ladungstransportschichten 26_1 und 26_2 den lateralen Transport von Ladungsträgern über die Breite bis der nicht leitenden Gitterteilbereiche 18a_1 oder 18b_1 bzw. 18a_2 oder 18b_2 sicherzustellen. Ebenfalls analog zu den oben genannten Ausführungsbeispielen dienen die (optionalen) Distanzschichten 30_1 und 30_2 dazu, die Position der Zwischenschichten 18_1 und 18_2 in der Schichtanordnung zu optimieren.

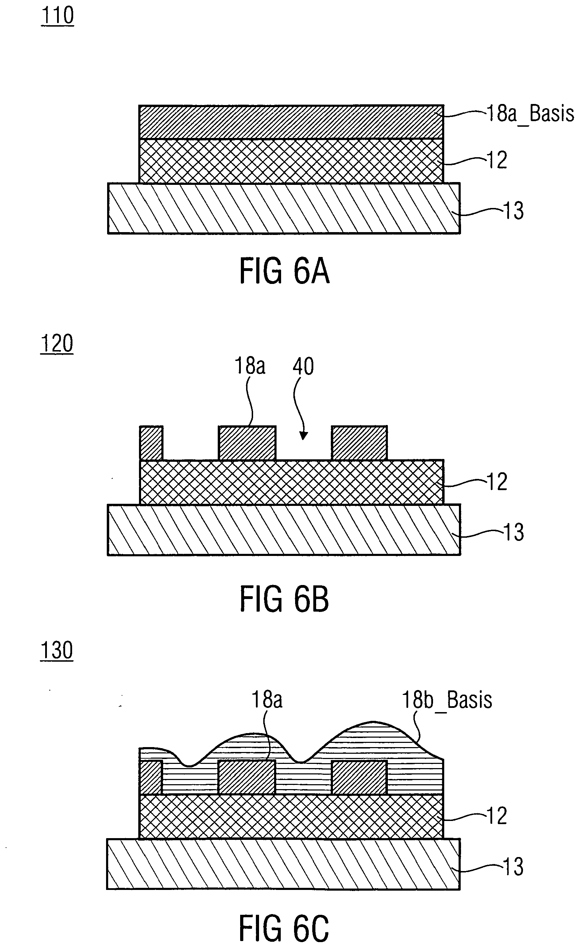

Im Folgenden wird nun anhand einer prinzipiellen Prozessfolge von Fig. 6a bis 6e ein beispielhaftes Herstellungsverfahren 100 der elektrolumineszenten Lichtemissionseinrichtung 1 gemäß einem Ausführungsbeispiel der vorliegenden Erfindung beschrieben. Ferner wird darauf hingewiesen, dass Bezug nehmend auf Fig. 6a bis 6d der Schritt des Erzeugens einer planarisierten Zwischenschicht 18 detailliert dargestellt ist.

Fig. 6a zeigt den Ausgangszustand des Verfahrens 100 zur Herstellung der Lichtemissionseinrichtung 1. Bei einem ersten Verfahrensschritt 110 wird das Substrat 13 bereitgestellt und auf dieses die erste Elektrodenschicht 12 aufgebracht. Desweiteren ist eine erste Gitterstruktur-Basisschicht 18a_Basis auf die Elektrodenschicht 12 aufgebracht, aus der nachfolgend dann erste Gitterteilbereiche 18a gebildet werden. Das Aufbringen bzw. Abscheiden der erste Gitterstruktur-Basisschicht 18a Basis auf die Elektrodenschicht 12 kann beispielsweise mittels chemischer Gasphasenabscheidung (CVD = chemical vapor deposition) einer SiO₂-Schicht erfolgen.

Fig. 6b illustriert den darauffolgenden Schritt 120 des Strukturierens der ersten Gitterstruktur-Basisschicht 18a _Basis. Die Darstellung zeigt die bereits strukturierte Gitterstruktur-Basisschicht, so dass diese die ersten, beabstandeten Gitterteilbereiche 18a bilden, sowie freigelegte Zwischenbereiche 40. In dem dargestellten Schritt wird die Gitterstruktur-Basisschicht 18a _Basis oder SiO₂-Schicht strukturiert, um erste, beabstandete Gitterteilbereiche 18a und freigelegte Zwischenbereiche 40 zu erhalten. Hierzu kann beispielsweise die SiO₂-Schicht mit einem Fotolack beschichtet werden, der danach durch fotolithografische Prozesse strukturiert wird. Diese Struktur kann dann durch reaktives Ionenätzen (RIE = reactive ion etching) in die SiO₂-Schicht übertragen werden.

Fig. 6c stellt den Schritt 130 des Aufbringens einer zweiten Gitterstruktur-Basisschicht 18b_Basis auf die ersten, beabstandeten Gitterteilbereiche 18a und die freigelegten Zwischenbereiche 40 dar. Hierbei wird eine zweite Gitterstruktur-Basisschicht 18b_Basis aus dotiertem amorphen Silizium (a-Si), auf die ersten, beabstandeten Gitterteilbereiche 18a und die freigelegten Zwischenbereiche 40, beispielsweise mittels chemischer Gasphasenabscheidung, aufgebracht.

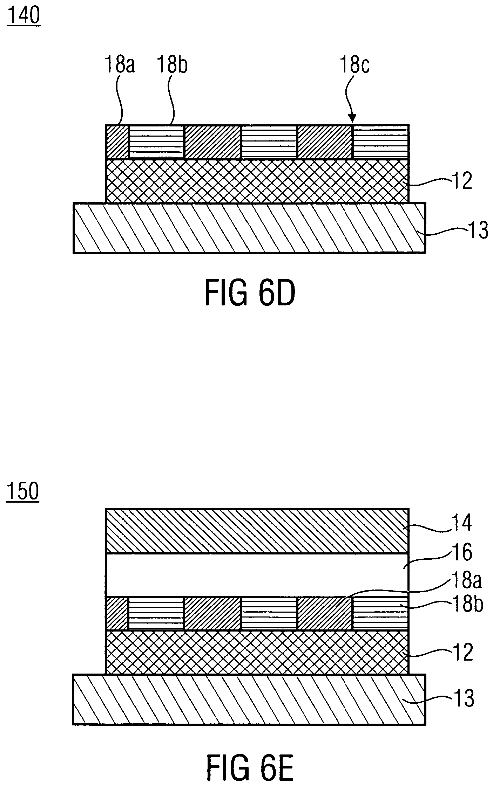

Fig. 6d stellt den nächsten Schritt 140 des Planarisierens der zweiten Gitterstruktur-Basisschicht 18b _Basis dar, so dass zweite Gitterteilbereiche 18b entstehen. Anschließend wird zumindest die zweite Gitterstruktur-Basisschicht planarisiert, um die planarisierte Zwischenschicht mit der optischen Gitterstruktur zu erhalten. Hierbei wird mittels eines chemischen-mechanischen Planarisierungsprozesses (CMP) die zweite Gitterstruktur-Basisschicht 18b_Basis bis auf die ersten (aufgewachsenen) Gitterteilbereiche 18a zurückpoliert. Durch Prozessselektivität bezüglich SiO₂ und a-Si kann auf den ersten Gitterteilbereichen 18a gestoppt werden. Die Schichtdicke h₁₈ und damit die Gitterhöhe kann dadurch gesteuert werden, dass im Planarisierungsprozess die ersten Gitterteilbereiche 18a teilweise mit abgetragen werden. Die resultierende Planarität der ersten Hauptoberfläche 18c ist prozessabhängig.

Fig. 6e zeigt den Abschlussschritt des Verfahrens zur Herstellung zur Illustration der letzten Schritte 150 des Aufbringens der lichtemittierenden Schicht 16 und der zweiten Elektrodenschicht 14. Nach dem Erzeugen der Zwischenschicht 18 wird die lichtemittierende Schicht 16, die beispielsweise mehreren Einzelschichten aufweisen kann, auf der Zwischenschicht 18 angeordnet, bevor die zweite Elektrodenschicht 14 auf der lichtemittierenden Schicht 16 aufgebracht wird.

Entsprechend weiteren Vergleichsbeispielen kann das oben beschriebene Herstellungsverfahren den Schritt des Anordnens der lateralen Ladungstransportschicht 26 nach dem Schritt des Erzeugens der planarisierten Zwischenschicht 18 bzw. nach dem Schritt des Planarisierens der Zwischenschicht 18 (vor dem Schritt des Anordnens der lichtemittierenden Schicht 16 auf die Zwischenschicht 18) aufweisen. Ebenso kann das Herstellungsverfahren den Schritt des Anordnens der Distanzschicht 30 auf die Elektrode 12 vor dem Erzeugen der Zwischenschicht 18 umfassen. Im Weiteren kann analog des oben beschriebenen Verfahrens eine Lichtemissionseinrichtung 32 entsprechend dem in Fig. 5 gezeigtem Ausführungsbeispiel hergestellt werden, wobei dann der Schritt des Erzeigens der Zwischenschicht einmal für die Zwischenschicht 18_1 und einmal für die Zwischenschicht 18_2 durchgeführt wird.

Entsprechend einem weiteren Ausführungsbeispiel kann die Schichtanordnung in Pixel und/oder Subpixel unterteilt sein. Durch die Unterteilung der Pixel ist es möglich, die Lichtemissionseinrichtung als Display zu nutzen. Indem Pixel in Subpixel untergliedert werden, die beispielsweise jeweils eine der drei Grundfarben darstellen können, ist es möglich, dass der Pixel verschiedene Farben darstellen kann, indem die drei Grundfarben mit unterschiedlicher Intensität gemischt werden. Um die Pixel bzw. Subpixel selektiv anzusteuern, kann die Lichtemissionseinrichtung entweder aktiv oder passiv gesteuert werden. Bei der aktiven Steuerung ist eine integrierte Schaltung auf dem Substrat angeordnet, die die Pixel selektiv ansteuert und die Stromversorgung für diese zur Verfügung stellt. Bei der passiven Ansteuerung wird die Lichtemissionseinrichtung mit mehreren Pixeln von außen über eine Matrix angesteuert und mit Strom versorgt. Bei der passiven Ausführungsform kann eine integrierte Schaltung zur Ansteuerung der Pixel ebenfalls auf demselben Substrat neben der Lichtemissionseinrichtung oder extern angeordnet sein.

Alternativ kann die Schichtanordnung der Lichtemissionseinrichtung weitere lichtemittierende Schichten aufweisen. Dadurch können beispielsweise in einem Bereich verschieden Farbdarstellungen realisiert werden, wenn z.B. drei verschiedenfarbige lichtemittierende Schichten übereinander angeordnet sind.

Bezug nehmend auf die Ausführungsbeispiele aus Fig. 2 und Fig. 4 wird angemerkt, dass in einem weiteren Ausführungsbeispiel eine Lichtemissionseinrichtung die Distanzschicht 30 aufweisen kann.

Bei einem weiteren alternativen Ausführungsbeispiel kann die Zwischenschicht 18 weitere Gitterteilbereiche neben den ersten und zweiten Gitterteilbereichen mit weiteren Brechungsindizes aufweisen.

Bezug nehmend auf Fig. 5 kann die Lichtemissionseinrichtung 32 einen Zwischenschichtstapel 18 mit weiteren Zwischenschichten 18_1, 18_2, 18_3, ... und 18_n aufweisen.

Es wird darauf hingewiesen, dass die beschriebenen Ausführungsbeispiele der Lichtemissionseinrichtung abhängig von den Materialeigenschaften des Substrats 13 und der Elektrodenschichten 12 und 14 sowohl als top-emitting OLED (TOLED) als auch als bottomemitting OLED (BOLED) und als transparente OLED eingesetzt werden können. Beispielsweise wird für TOLEDs, im Gegensatz zu BOLEDs, ein opakes Substrate 13, eine reflektierenden Elektrodenschichten 12 und eine transparente Elektrodenschichten 14 verwendet.

Bezug nehmend auf die im Vorherigen dargestellten Ausführungsbeispiele wird darauf hingewiesen, dass der Aufbau der Lichtemissionseinrichtung flächig und/oder in Pixel bzw. Subpixel unterteilt sein kann und deshalb eine flächige Abstrahlung des emittierten Lichts und/oder eine Abstrahlung in Pixeln oder Subpixeln erfolgen kann.

### Referenzen

[1] C. Adachi, M. A. Baldo, S.R. Forrest, and M. E. Thompson, "Nearly 100% internal phosphorescence efficiency in an organic light-emitting device", J. Appl. Phys. 90, 5048 (2001)
[2] S. Möller and S. R. Forrest, "Improved light out-coupling in organic light emitting diodes employing ordered microlens arrays", J. Appl. Phys. 81, 3324 (2002)
[3] J. Zhou, N. Ai, L. Wang, H. Zheng, C. Luo, Z. Jiang, S. Yu, Y. Cao and J. Wang, "Roughening the white OLED substrate's surface through sandblasting to improve the external quantum efficiency", Org. Electronics 12, 648-(2011)
[4] T. Yamasaki, K. Sumioka, and T. Tsutsui, "Organic light-emitting device with an ordered monolayer of silica microspheres as a scattering medium", Appl. Phys. Lett. 76, 1243 (2000)
[5] T. Tsuitsui, M. Yahiro, H. Yokogawa, K. Kawano, Y. Yokoyama, "Doubling Coupling-Out Efficiency in Organic Light-Emitting Devices Using a Thin Silica Aerogel Layer", Adv. Mater. 13, 2174 (2001)
[6] Y. R. Do, Y.-C. Kim, Y.-W. Song, S.-H. Lee, "Enhanced light extraction efficiency from organic light emitting diodes by insertion of a two-dimensional photonic crystal structure", J. Appl. Phys. 96, 7629 (2004)
[7] B. J. Matterson, J. M. Lupton, A. F. Safonov, M. G. Salt, W. L. Barnes, I. D. W. Samuel, "Increased Efficiency and Controlled Light Output from Microstructured Light-Emitting Diode", Adv. Mat. 13, 2 (2001)
[8] M. Fujita, K. Ishihara, T. Ueno, T. Asano, S. Noda, H. Ohata, T. Tsuji, H. Nakada, N. Shimoji, "Optical and Electrical Characteristics of Organic Light-Emitting Diodes with Two-Dimensional Photonic Crystals in Organic/Electrode Layers", Jap. J. of Appl. Phys. 44, 6A (2005)
[9] U. Geyer, J. Hauss, B. Riedel, S. Gleiss, U. Lemmer, M. Gerken, "Large-scale patterning of indium tin oxide electrodes for guided mode extraction from organic light-emitting diodes", J. Appl. Phys. 104, 093111 (2008)
[10] J. Feng, T. Okamoto, R. Naraoka, S. Kawata, "Enhancement of surface plasmonmediated radiative energy transfer through a corrugated metal cathode in organic light-emitting devices", Appl. Phys. Lett. 93, 061106 (2008)
[11] G. Garcia-Belmonte, J. M. Montero, Y. Ayyad-Limonge, E.M: Barea, J. Bisquert, H. J. Bolink, "Perimeter leakage current in polymer light emitting diodes", Curr. Appl. Phys. 9, 414 (2009)

## Patentansprüche

1. Lichtemissionseinrichtung (1, 24, 28, 32) mit folgenden Merkmalen:
einem Substrat (13); und
einer auf dem Substrat (13) aufgebrachten Schichtanordnung (10) mit einer auf dem Substrat (13) angeordneten ersten Elektrodenschicht (12) aus einem leitfähigen Material, mit einer zweiten Elektrodenschicht (14) aus einem leitfähigen Material, mit zumindest einer lichtemittierenden Schicht (16) aus einem organischen Material, die zwischen der ersten Elektrodenschicht (12) und der zweiten Elektrodenschicht (14) angeordnet ist und als organischer Schichtstapel (16) ausgeführt ist, und mit zumindest einer eine optische Gitterstruktur aufweisende Zwischenschicht (18), die zwischen dem organischen Schichtstapel (16) und der ersten Elektrodenschicht (12) angeordnet ist,
wobei eine erste Hauptoberfläche (18c) der Zwischenschicht (18) dem organischen Schichtstapel (16) zugewandt ist und die erste Hauptoberfläche (18c) der Zwischenschicht (18) zumindest im Bereich der optischen Gitterstruktur innerhalb eines fertigungsbedingten Toleranzbereichs planar ausgebildet ist, wobei im lichtemittierenden Bereich der Zwischenschicht (18) der Toleranzbereich im Bereich der Unebenheiten der ersten Hauptoberfläche (18c) in einem Bereich von weniger als +/- 20 nm oder bevorzugt +/- 10 nm liegt;
und wobei die Zwischenschicht (18) zumindest bereichsweise zwischen der ersten Hauptoberfläche (18c) und einer zweiten Hauptoberfläche (18d) derselben leitfähig ist,
wobei die Zwischenschicht (18) erste und zweite Gitterteilbereiche (18a, 18b) umfasst, wobei die ersten und zweiten Gitterteilbereiche (18a, 18b) nebeneinander angeordnet sind und wobei die ersten und zweiten Gitterteilbereiche (18a, 18b) eine gleiche Schichthöhe aufweisen, um so eine konstante Schichtdicke (h₁₈) der Zwischenschicht (18) auszubilden, und wobei der erste Gitterteilbereich (18a) ein dotiertes amorphes Silizium und der zweiten Gitterteilbereich (18b) ein Siliziumoxid aufweist;
wobei der organische Schichtstapel (16) eine Löchertransportschicht (16a), eine Elektronenblockerschicht (16b), eine lichtemittierende Schicht 16c), eine Löcherblockerschicht (16d) und eine Elektronentransportschicht (16e) aufweist ; und
wobei die erste Hauptoberfläche (18c) der Zwischenschicht (18) und organische Schichtstapel (16) direkt einander angrenzend sind.

2. Lichtemissionseinrichtung (1, 24, 28, 32) gemäß Anspruch 1, wobei die Periodenlänge (b₁₈ₐ + b_{18b}) der optischen Gitterstruktur zumindest bereichsweise auf eine Wellenlänge des von der lichtemittierenden Schicht (16) zu emittierenden Lichts eingestellt ist.

3. Lichtemissionseinrichtung (1, 24, 28, 32) gemäß einem der vorherigen Ansprüche, wobei die Periodenlänge (b₁₈ₐ + b_{18b}) der Gitterstruktur der Zwischenschicht (18) in einem Bereich von 0, 2 bis 5, 0 der Wellenlänge des von der lichtemittierenden Schicht (16) zu emittierenden Lichts liegt.

4. Lichtemissionseinrichtung (1, 24, 28, 32) gemäß einem der vorherigen Ansprüche, wobei die Schichtanordnung (10) zusätzlich eine homogene, leitfähige Distanzschicht (30) zwischen der Zwischenschicht (18) und der ersten Elektrodenschicht (12) aufweist.

5. Lichtemissionseinrichtung (1, 24, 28, 32) gemäß einem der vorherigen Ansprüche, wobei die optische Gitterstruktur der Zwischenschicht (18) einem schiefwinkligen, rechtwinkligen, rechtwinklig zentrierten, hexagonalen oder quadratischen Bravaisgitter entspricht oder als Quasikristall ausgebildet ist.

6. Lichtemissionseinrichtung (1, 24, 28, 32) gemäß einem der vorherigen Ansprüche, wobei die Schichtdicke (h₁₈) der Zwischenschicht (18) innerhalb eines weiteren Toleranzbereichs konstant und kleiner als 1000 nm ist.

7. Lichtemissionseinrichtung (1, 24, 28, 32) gemäß einem der vorherigen Ansprüche, wobei die Schichtanordnung (10) in Pixel und/oder Subpixel unterteilt ist, die selektiv, passiv oder aktiv mittels einer integrierten Schaltung ansteuerbar sind.

8. Lichtemissionseinrichtung (1, 24, 28, 32) gemäß einem der vorherigen Ansprüche, wobei der Zwischenschicht (18) und die erste und zweite Elektrodenschicht (12, 14) unterschiedliche, leitfähige Materialen aufweisen.

9. Lichtemissionseinrichtung (1, 24, 28, 32) gemäß einem der vorherigen Ansprüche, wobei die Schichtanordnung (10) eine weitere Zwischenschicht (18_2) mit einer weiteren optischen Gitterstruktur aufweist, die zwischen der ersten Zwischenschicht (18_1) und der ersten Elektrodenschicht (12) angeordnet ist, wobei eine erste Hauptoberfläche (18c_2) der weiteren Zwischenschicht (18_2) der lichtemittierenden Schicht (16) zugewandt ist und die erste Hauptoberfläche (18c_2) der weiteren Zwischenschicht (18_2) zumindest im Bereich der optischen Gitterstruktur innerhalb eines Toleranzbereichs planar ausgebildet ist, und wobei die weitere Zwischenschicht zumindest bereichsweise zwischen der ersten Hauptoberfläche (18c_2) und einer zweiten Hauptoberfläche (18d_2) derselben leitfähig ist.

10. Verfahren (100) zur Herstellung einer Lichtemissionseinrichtung (1, 24, 28, 32) nach einem der vorherigen Ansprüche mit einer Schichtanordnung (10), mit folgenden Schritten:
Bereitstellen (110) des Substrats (13);
Anordnen (110) der ersten Elektrodenschicht (12) auf dem Substrat (13);
Erzeugen (110, 120, 130, 140) der die optische Gitterstruktur aufweisende, planarisierte Zwischenschicht (18) auf der Elektrodenschicht (12);
Anordnen (150) des organischen Schichtstapels (16) auf der Zwischenschicht (18); und
Anordnen (150) der zweiten Elektrodenschicht (14) auf dem organischen Schichtstapel (16),
wobei der Schritt des Erzeugens der Zwischenschicht folgende Schritte aufweist:
Aufbringen (110) der ersten Gitterstruktur-Basisschicht (18a_Basis) auf der Elektrodenschicht (12);
Strukturieren (120) der ersten Gitterstruktur-Basisschicht (18a_Basis), um erste, beabstandete Gitterteilbereiche (18a) und freigelegte Zwischenbereiche (40) zu erhalten;
Aufbringen (130) einer zweiten Gitterstruktur-Basisschicht (18b_Basis) auf den ersten, beabstandeten Gitterteilbereichen (18a) und den freigelegten Zwischenbereichen (40); und
Planarisieren (140) zumindest der zweiten Gitterstruktur-Basisschicht (18b_Basis), um die planarisierte Zwischenschicht (18) mit der optischen Gitterstruktur zu erhalten.

## Claims

1. A light emission device (1, 24, 28, 32) comprising:
a substrate (13); and
a layer arrangement (10) applied onto the substrate (13), comprising a first electrode layer (12) made of a conductive material, arranged on the substrate (13), a second electrode layer (14) made of a conductive material, at least one light-emitting layer (16) made of an organic material, arranged between the first electrode layer (12) and the second electrode layer (14) and formed as an organic layer stack (16), and at least one intermediate layer (18) comprising an optical lattice structure, arranged between the organic layer stack (16) and the first electrode layer (12),
wherein a first main surface (18c) of the intermediate layer (18) faces the organic layer stack (16) and the first main surface (18c) of the intermediate layer (18) is formed to be planar within a manufacturing-induced tolerance range at least in the region of the optical lattice structure, wherein, in the light-emitting region of the intermediate layer (18), the tolerance range in the region of unevenness of the first main surface (18c) is in a range of less than +/- 20 nm and preferably +/- 10 nm; and wherein the intermediate layer (18) is conductive at least in regions between the first main surface (18c) and a second main surface (18d) thereof,
wherein the intermediate layer (18) includes first and second lattice sub-regions (18a, 18b), the first and second lattice sub-regions (18a, 18b) being arranged next to each other, and the first and second lattice sub-regions (18a, 18b) comprising an equal layer thickness so as to form a constant layer thickness (h₁₈) of the intermediate layer (18), and wherein the first lattice sub-region (18a) comprises doped amorphous silicon and the second lattice sub-region (18b) comprises silicon oxide;
wherein the organic layer stack (16) comprises a hole transport layer (16a), an electron blocking layer (16b), a light-emitting layer (16c), a hole blocking layer (16d) and an electron transport layer (16e); and
wherein the first main surface (18c) of the intermediate layer (18) and the organic layer stack (16) are directly adjacent to each other.

2. The light emission device (1, 24, 28, 32) in accordance with claim 1, wherein the period length (b₁₈ₐ + b_{18b}) of the lattice structure is set at least in regions to a wavelength of the light to be emitted by the light-emitting layer (16).

3. The light emission device (1, 24, 28, 32) in accordance with any of the preceding claims, wherein the period length (b₁₈ₐ + b_{18b}) of the lattice structure of the intermediate layer (18) is in a range of 0.2 to 5.0 times the wavelength of the light to be emitted by the light-emitting layer (16).

4. The light emission device (1, 24, 28, 32) in accordance with any of the preceding claims, wherein the layer arrangement (10) additionally comprises a homogenous conductive distance layer (30) between the intermediate layer (18) and the first electrode layer (12).

5. The light emission device (1, 24, 28, 32) in accordance with any of the preceding claims, wherein the optical lattice structure of the intermediate layer (18) corresponds to an oblique-angled, rectangular, rectangular-centered, hexagonal or squared Bravais lattice or is formed as a quasi-crystal.

6. The light emission device (1, 24, 28, 32) in accordance with any of the preceding claims, wherein the layer thickness (h₁₈) of the intermediate layer (18) is constant within another tolerance range and is smaller than 1000 nm.

7. The light emission device (1, 24, 28, 32) in accordance with any of the preceding claims, wherein the layer arrangement (10) is subdivided into pixels and/or subpixels which may be driven selectively, passively or actively by means of an integrated circuit.

8. The light emission device (1, 24, 28, 32) in accordance with any of the preceding claims, wherein the intermediate layer (18) and the first and second electrode layers (12, 14) comprise different conductive materials.

9. The light emission device (1, 24, 28, 32) in accordance with any of the preceding claims, wherein the layer arrangement (10) comprises another intermediate layer (18_2) comprising another optical lattice structure arranged between the first intermediate layer (18_1) and the first electrode layer (12), a first main surface (18c_2) of the further intermediate layer (18_2) facing the light-emitting layer (16) and the first main surface (18c_2) of the further intermediate layer (18_2) being formed to be planar within a tolerance range at least in the region of the optical lattice structure, and the further intermediate layer being conductive at least in regions between the first main surface (18c_2) and a second main surface (18d_2).

10. A method (100) for manufacturing a light emission device (1, 24, 28, 32) in accordance with any of the preceding claims, comprising a layer arrangement (10), comprising:
providing (110) the substrate (13);
arranging (110) the first electrode layer (12) on the substrate (13);
generating (110, 120, 130, 140) the planarized intermediate layer (18) comprising the optical lattice structure, on the electrode layer (12);
arranging (150) the organic layer stack (16) on the intermediate layer (18); and
arranging (150) the second electrode layer (14) on the organic layer stack (16),
wherein the step of generating the intermediate layer comprises:
applying (110) the first lattice structure base layer (18a_base) on the electrode layer (12);
patterning (120) the first lattice structure base layer (18a_base) so as to obtain first spaced-apart lattice sub-regions (18a) and exposed intermediate regions (40);
applying (130) a second lattice structure base layer (18b_base) on the first spaced-apart lattice sub-regions (18a) and the exposed intermediate regions (40); and
planarizing (140) at least the second lattice structure base layer (18b_base) so as to obtain the planarized intermediate layer (18) comprising the optical lattice structure.

## Revendications

1. Dispositif d'émission de lumière (1, 24, 28, 32), aux caractéristiques suivantes:
un substrat (13); et
un aménagement de couches (10) appliqué sur le substrat (13) avec une première couche d'électrodes (12) en un matériau conducteur disposée sur le substrat (13), avec une deuxième couche d'électrodes (14) en un matériau conducteur, avec au moins une couche électroluminescente (16) en un matériau organique qui est disposée entre la première couche d'électrodes (12) et la deuxième couche d'électrodes (14) et est réalisée en forme de pile de couches organiques (16), et avec au moins une couche intermédiaire (18) présentant une structure de grille optique et qui est disposée entre la pile de couches organiques (16) et la première couche d'électrodes (12),
dans lequel une première surface principale (18c) de la couche intermédiaire (18) fait face à la pile de couches organiques (16) et la première surface principale (18c) de la couche intermédiaire (18) est réalisée plane au moins dans la zone de structure de grille optique dans une plage de tolérance conditionnée par la fabrication, dans lequel, dans la zone électroluminescente de la couche intermédiaire (18), la plage de tolérance dans la zone des irrégularités de la première surface principale (18c) se situe dans une plage de moins de +/- 20 nm ou de préférence de +/- 10 nm; et dans lequel la couche intermédiaire (18) est conductrice au moins par zones entre la première surface principale (18c) et une deuxième surface principale (18d) de cette dernière,
dans lequel la couche intermédiaire (18) comporte des premières et deuxièmes zones de grille partielles (18a, 18b), dans lequel les premières et deuxièmes zones de grille partielles (18a, 18b) sont disposées l'une à côté de l'autre et dans lequel les premières et deuxièmes zones de grille partielles (18a, 18b) présentent une même hauteur de couche, pour former ainsi une épaisseur de couche constante (h₁₈) de la couche intermédiaire (18), et dans lequel la première zone de grille partielle (18a) présente un silicium amorphe dopé et la deuxième zone de grille partielle (18b) présente un oxyde de silicium;
dans lequel la pile de couches organiques (16) présente une couche de transport à trous (16a), une couche de blocage d'électrons (16b), une couche électroluminescente 16c), une couche de blocage de trous (16d) et une couche de transport d'électrons (16e); et
dans lequel la première surface principale (18c) de la couche intermédiaire (18) et la pile de couches organiques (16) sont directement adjacentes l'une à l'autre.

2. Dispositif d'émission de lumière (1, 24, 28, 32) selon la revendication 1, dans lequel la longueur de période (b₁₈ₐ + b_{18b}) de la structure de grille optique, au moins par zones, est réglée à une longueur d'onde de la lumière à émettre par la couche électroluminescente (16).

3. Dispositif d'émission de lumière (1, 24, 28, 32) selon l'une des revendications précédentes, dans lequel la longueur de période (b₁₈ₐ + b_{18b}) de la structure de grille de la couche intermédiaire (18) se situe dans une plage de 0,2 à 5,0 de la longueur d'onde de la lumière à émettre par la couche électroluminescente (16).

4. Dispositif d'émission de lumière (1, 24, 28, 32) selon l'une des revendications précédentes, dans lequel l'aménagement de couches (10) présente en outre une couche d'espacement conductrice homogène (30) entre la couche intermédiaire (18) et la première couche d'électrodes (12).

5. Dispositif d'émission de lumière (1, 24, 28, 32) selon l'une des revendications précédentes, dans lequel la structure de grille optique de la couche intermédiaire (18) correspond à une grille de Bravais oblique, à angle droit, centré à angle droit, hexagonal ou carré ou est réalisée en forme d'un quasi-cristal.

6. Dispositif d'émission de lumière (1, 24, 28, 32) selon l'une des revendications précédentes, dans lequel l'épaisseur de couche (h₁₈) de la couche intermédiaire (18) est constante dans une autre plage de tolérance et est inférieure à 1000 nm.

7. Dispositif d'émission de lumière (1, 24, 28, 32) selon l'une des revendications précédentes, dans lequel l'aménagement de couches (10) est subdivisé en pixels et/ou sous-pixels qui peuvent être commandés de manière sélective, passive ou active au moyen d'un circuit intégré.

8. Dispositif d'émission de lumière (1, 24, 28, 32) selon l'une des revendications précédentes, dans lequel la couche intermédiaire (18) et la première et la deuxième couche d'électrodes (12, 14) présentent des matériaux conducteurs différents.

9. Dispositif d'émission de lumière (1, 24, 28, 32) selon l'une des revendications précédentes, dans lequel l'aménagement de couches (10) présente une autre couche intermédiaire (18_2) avec une autre structure de grille optique qui est disposée entre la première couche intermédiaire (18_1) et la première couche d'électrodes (12),
dans lequel une première surface principale (18c_2) de l'autre couche intermédiaire (18_2) fait face à la couche électroluminescente (16) et la première surface principale (18c_2) de l'autre couche intermédiaire (18_2) est réalisée plane au moins dans la zone de la structure de grille optique dans une plage de tolérance, et dans lequel l'autre couche intermédiaire est conductrice au moins par zones entre la première surface principale (18c_2) et une deuxième surface principale (18d_2) de cette dernière.

10. Procédé (100) de fabrication d'un dispositif d'émission de lumière (1, 24, 28, 32) selon l'une des revendications précédentes avec un aménagement de couches (10), aux étapes suivantes consistant à:
prévoir (110) le substrat (13);
disposer (110) la première couche d'électrodes (12) sur le substrat (13);
générer (110, 120, 130, 140) la couche intermédiaire aplanie (18) présentant la structure de grille optique sur la couche d'électrodes (12);
disposer (150) la pile de couches organiques (16) sur la couche intermédiaire (18); et
disposer (150) la deuxième couche d'électrodes (14) sur la pile de couches organiques (16),
dans lequel l'étape consistant à générer la couche intermédiaire présente les étapes suivantes consistant à:
appliquer (110) la première couche de base à structure de grille (18a_Basis) sur la couche d'électrodes (12);
structurer (120) la première couche de base à structure de grille (18a_Basis) pour obtenir des premières zones de grille partielles distantes l'une de l'autre (18a) et des zones intermédiaires exposées (40);
appliquer (130) une deuxième couche de base à structure de grille (18b_Basis) sur les premières zones de grille partielles distantes l'une de l'autre (18a) et les zones intermédiaires exposées (40); et
aplanir (140) au moins la deuxième couche de base à structure de grille (18b_Basis) pour obtenir la couche intermédiaire aplanie (18) à la structure de grille optique.
